# EUROPEAN PATENT APPLICATION

(11) **EP 1 484 946 A2**
(43) Date of publication of application: **08.12.2004**
(21) Application number: 04013252.4
(22) Date of filing: 04.06.2004
(51) Int. Cl.: H05B 33/10, G02F 1/1335

(54) **Organic electroluminescent display panel, method of manufacturing it and display device equiped with the panel**

(30) Priority: 06.06.2003 JP 2003162687
(71) Applicant: Seiko Epson Corporation, Shinjuku-ku, Tokyo 163-0811 (JP)
(72) Inventor: Yotsuya, Shinichi Seiko Epson Corp., Nagano-ken 392-8502 (JP)
(74) Representative: Hoffmann, Eckart, Dipl.-Ing.

(57) **Abstract**

An organic electroluminescent display device and a method of manufacturing it are provided that enable to form a microlens (17) without affecting an organic luminescent layer (14) during the manufacturing process, and to easily manufacture an organic electroluminescent display device with increased light output efficiency. A lens pattern (17a) corresponding to a microlens (17) that refracts the light from an organic luminescent layer (14) is formed by photolithographic treatment on a transparent resin film formed on a substrate (11), and the microlens (17) is formed by reflow treatment on the lens pattern.

## Description

The present invention relates to an organic electroluminescent display device and a method of manufacturing it, the organic electroluminescent display device making a display through the light-emitting state of a plurality of organic luminescent layers.

Current display devices can be classified into CRTs (Cathode Ray Tubes) and flat display panels composed of various types of elements. Flat display panels are light-weight and have a better luminous efficiency than CRTs, and have been developed over the years for use as monitor screens for computers and televisions and the like. Recently, research is focusing on active matrix driven organic EL (Electroluminescence) displays.

In an organic EL display a thin film including a fluorescent inorganic and organic compound is sandwiched between a cathode and an anode; an array of elements of such structure are provided that are selectively induced to emit light using the radiation of light (fluorescence, phosphorescence) produced when excitons decay that have been generated by recombination of electrons and holes injected into the thin film. Such active matrix driven organic EL displays are getting a lot of attention as they feature a thin structure and high resolution.

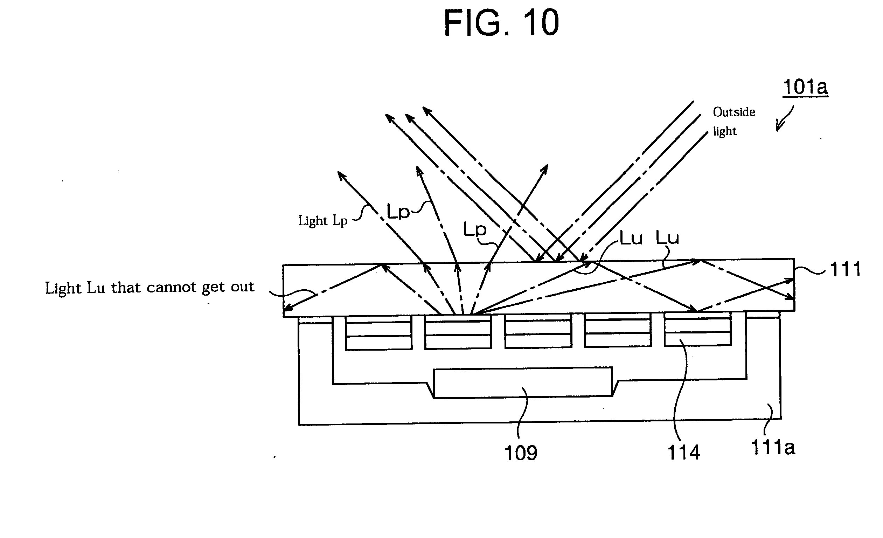

FIG. 10 is a sectional view showing an example of a configuration of an organic EL panel 101a included in a conventional organic EL display.

The organic EL panel 101a has a light-emitting element 114 and a desiccant 109 sealed through a transparent glass 111 and a sealing glass 111 a. In this organic EL panel 101 a, the space sealed by the glass 111 and the sealing glass 111a is desiccated by the desiccant 109, and light Lp emitted by a light-emitting element 114 crosses the glass 111 and is emitted to the outside.

With surface emitting elements such as the organic panel 101 a, a problem is encountered in that light is lost and thus the light output efficiency is poor, as the light Lp from the pixel including the light-emitting element 114 is diffused in all directions and light Lu, having an angle exceeding the critical angle with regard to the surface of the glass 111, cannot be emitted to the outside of the glass 111 due to a total reflection phenomenon.

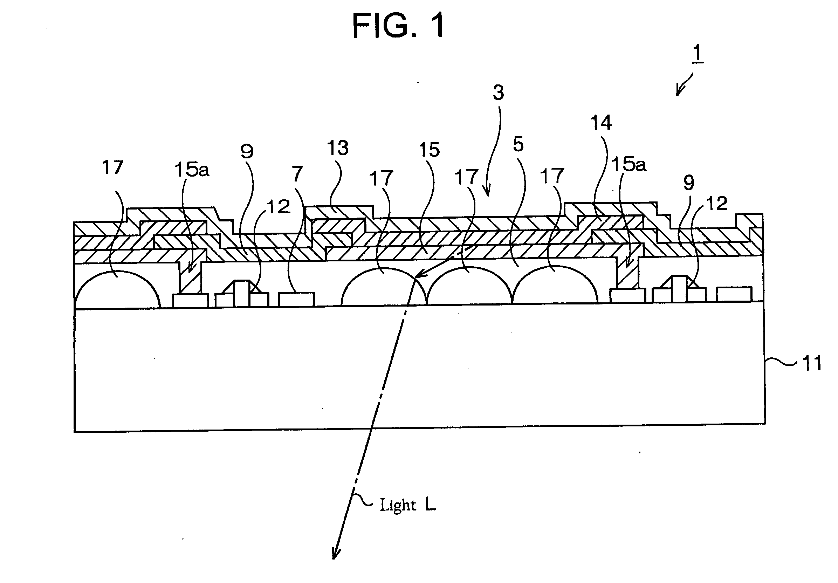

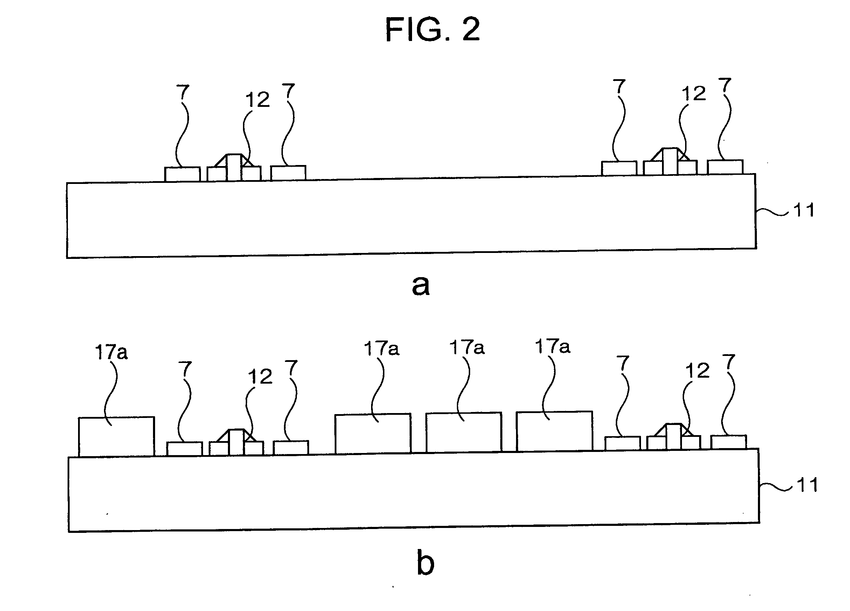

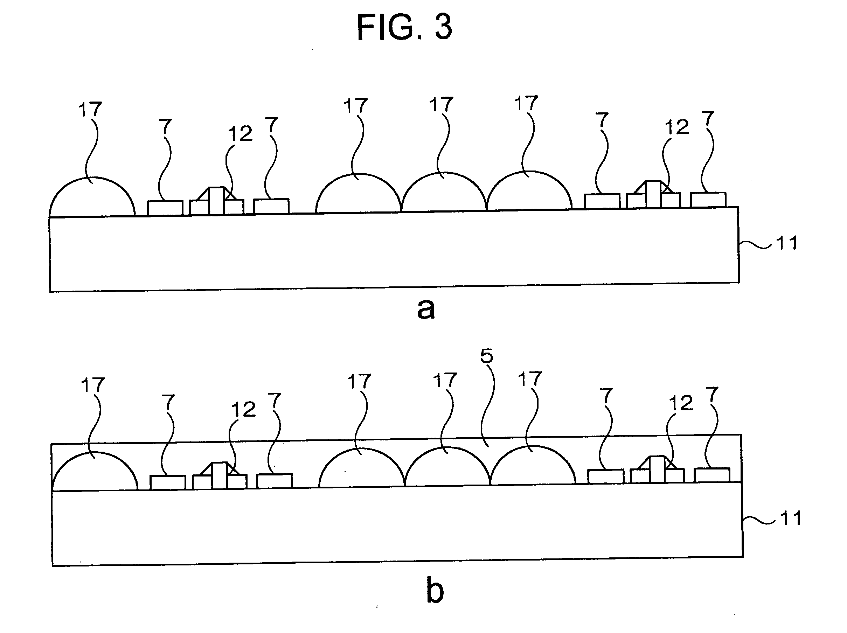

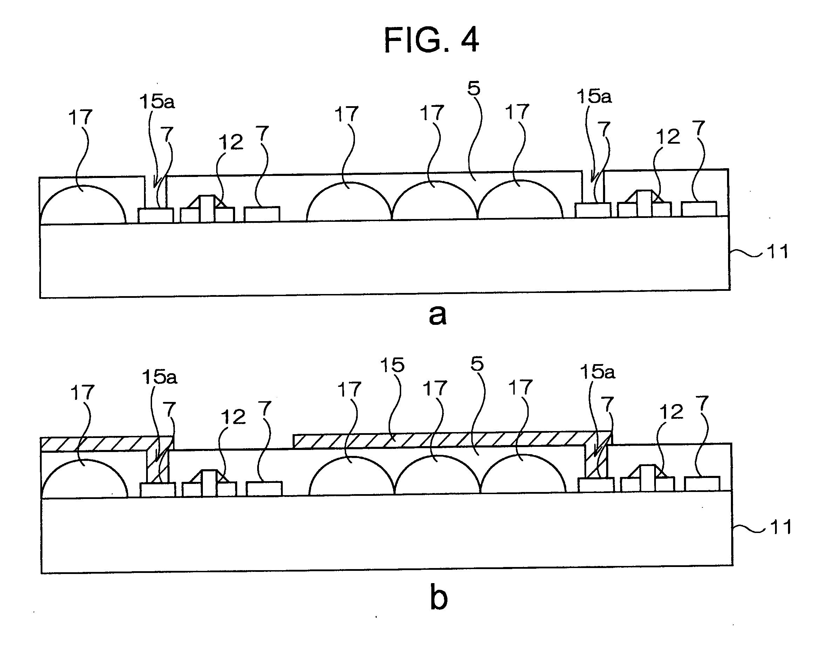

JP 10-172756 A discloses an organic EL light-emitting device designed to solve such problems. This known organic EL light-emitting device has a microlens 2 located inside a light transmissive base board 1 as shown in FIG. 1 of the document, a microlens 22 located inside a light transmissive base board 21 as shown in FIG. 2 of the document, and microlenses 32 and 33 located inside a light transmissive base board 31 as shown in FIG. 3 of the document. However, with such a conventional configuration, it is difficult and thus costly to place the microlens 2 inside the light transmissive base board 1. Further, in its FIG. 4, this document JP 10-172756 A, shows a configuration wherein a microlens 42 is provided inside a backing layer 43 that is formed on a light transmissive base board 41. In the case of this known organic EL light-emitting device 40, the microlens inside the backing layer 43 has a convexly curved surface form on the side of the light transmissive base board 41 rather than on the side of the lower electrode 44a. Compared to the organic EL light-emitting device 10 shown in FIG. 1 and others of JP 10-172756 A, the difficulty with manufacturing is seemingly resolved because the microlens 42 is not formed inside the light transmissive base board 41 anymore. However, in such an organic EL light-emitting device 40, as the microlens 42 inside the backing layer 43 has a convex surface on the side of the translucent substrate 41, a problem exists in that, when the light from a light-emitting layer 44b that is provided between an opposed electrode 44c and the lower electrode 44a is refracted, the margin of the critical angle is small, at which the light ends up being reflected inside the microlens 42 instead of being transmitted through the light transmissive base board 41.

Further, in JP 10-172756 A, no concrete manufacturing procedure is disclosed regarding the organic EL light-emitting device 40 shown in FIG. 4 thereof. Further, for the active matrix driven organic EL light-emitting device 40, the manufacture itself seems problematical, as the substrate process becomes a high temperature process of about 500 °C that requires the microlens 42 itself to be able to withstand such high temperatures.

The present invention is intended to solve the above-mentioned problems and its object is to provide a method of manufacturing an organic electroluminescent display device, an organic electroluminescent display panel, and a display device equipped with the panel that enable to form a microlens without affecting an organic luminescent layer during the manufacturing process, and to easily manufacture an organic electroluminescent display device with increased light output efficiency.

This object is achieved by a method as claimed in claim 1 and a display panel as claimed in claim 5. Preferred embodiments of the invention are subject-matter of the dependent claims.

With the claimed configuration, a microlens can be easily formed by performing photolithography and reflow treatment on a transparent resin before the organic luminescent layer is formed. Therefore, an adverse affect on the heat-sensitive organic luminescent layer when forming the microlens can be avoided.

Preferred embodiments of the invention will be explained below with reference to the drawings, in which:
- FIG. 1: is a sectional view showing an example of a configuration of an organic EL panel in accordance with an embodiment of the invention;

- FIGS. 2: to 6 are sectional views illustrating steps of an example of a manufacturing method of the organic EL panel;
- FIG. 7: is a sectional view illustrating an alternative method step;
- FIG. 8: is a sectional view showing an example of an application of the organic EL panel in accordance with the present embodiment;
- FIG. 9: is a sectional view showing an example of an application of the organic EL panel in accordance with the present embodiment;
- FIG. 10: is a sectional view showing an example of a conventional configuration of an organic EL panel.

FIG. 1 is a sectional view of one embodiment of an organic electroluminescent panel 1 (simply referred to as "EL panel" hereinafter) according to the present invention.

The EL panel 1 is to be mounted in a display device, and includes a substrate 11, arrays of microlenses 17, a low refractive index resin 5, transistors 12, a wiring 7, insulating layers 9, and a plurality of (organic) EL elements each comprising an anode 15, an organic luminescent layer 14 (referred to as "OL layer hereinafter), and a cathode 13. This EL panel 1 is a sealant substrate light-emitting organic EL panel that emits light from the surface of the substrate 11 towards the outside (lower part of the drawing).

The substrate 11 is a transparent substrate like a glass plate. On this substrate, a layer of the resin 5 is provided. Inside this resin 5, arrays of microlenses 17 are formed. Also within this resin 5, the transistors 12, the wiring 7 and opening parts 15a that extend from the anodes 15 are provided.

The microlenses 17 are composed of a transparent resin with a high refractive index, for example a refractive index (nD) from 1.5 to 1.8. On the other side, the resin 5 has a low refractive index, for example a refractive index (nD) from 1.2 to less than 1.5. It is preferable for the refractive index (nD) of the microlenses 17 to be 1.5 or more, because the larger the difference between the refractive index of the resin 5 and that of the microlenses 17, the stronger the power of the microlenses, and thereby all of the scattered light (light arriving at the microlens 17 from various directions) is sufficiently refracted to exceed the critical angle, i.e., is refracted by the microlens to reach the interface between the microlens 17 and the substrate 11 at an angle larger then the critical angle, and the EL panel 1 can have a minimum of loss of light. If it is less than 1.5, there is a risk of a total reflection phenomenon occurring at the interface with the substrate 11 having a refractive index (nD) of for example 1.5.

Further, it is preferable for the refractive index of the microlenses 17 to be 1.8 or less, because a refractive index of the microlenses 17 exceeding 1.8 leads to a combination where the difference in refractive index between the microlenses and the resin 5 exceeds 0.6. In that combination there is a risk that the reflection at the interface gets too large and the light output efficiency thus decreases.

On the other hand, it is preferable for the refractive index of the resin 5 to be 1.2 or more, as it otherwise leads to a combination where the difference in refractive index between the resin 5 and the microlenses 17 exceeds 0.6 with the result just mentioned. Further, it is preferable for the refractive index of the resin 5 to be less than 1.5, as it otherwise leads to a combination where the difference in refractive index between the resin 5 and the microlenses 17 falls below 0.1. In that combination the power of the microlenses is weak, and not all of the scattered can be refracted to exceed the critical angle, leading to an EL panel 1 with a large loss of light.

With such a configuration, all of the scattered light can be refracted to exceed the critical angle, and an EL panel 1 can be achieved with a minimum of loss of light.

Further, the diameter of the microlenses 17 is preferably from 1 µm to 50 µm. It is preferable for this diameter to be 1 µm or more, as otherwise, due to a diffraction phenomenon of the light, the focal power of the microlenses decreases and becomes too small. Further, it is preferable for the diameter of the microlenses 17 to be 50 µm or less, because when the diameter exceeds 50 µm, the distance between a light-emitting part and the corresponding microlens 17 is too close compared with the focal distance of the microlens, and therefore not all of the scattered light can be refracted to exceed the critical angle, leading to an increase in negative influences such as an increased loss of light. Further, when therefore forming the light-emitting part in a position apart, close to the focal distance, not all of the scattered light can be made to enter the microlens that is directly below the light-emitting part, and some will enter the microlens 17 of a different light-emitting part , thereby creating the risk of inducing a crosstalk phenomenon.

With such a configuration, the EL panel 1 can be achieved with a minimum of loss of light by choosing the optimum diameter of the microlenses 17 to be 1 µm to 50 µm.

On the resin 5, the cathodes 13, the OL layers 14 and the anodes 15 are provided. The cathodes and the anodes are provided to intersect each other so as to define a matrix structure. The cathode 13, the organic luminescent layer 14 and the anode 15 at each intersection of a cathode and an anode compose an (organic) EL element. Plural such EL elements are provided on the low refractive index resin 5, each representing a pixel 3. Further, on the substrate 11 the transistors 12 are provided as switching elements that are controlled by the intersecting cathodes 13 and anodes 15.

Each transistor 12 has the function to control the light-emitting state of the respective organic luminescent layer 14 that is provided between the corresponding cathode 13 and anode 15. That is to say, this transistor 12 has the function to actively drive the EL element that includes the respective organic luminescent layer 14. Further, to insulate the OL layers 14 from one another on the resin 5 the insulating layers 9 are provided.

Each OL layer 14 is associated with at least one microlens 17. In the present embodiment, a microlens array of more than one microlens 17 is provided for each OL layer 14 (each EL element). With such a configuration, due to the existence of more than one microlens 17, the efficiency of the light output and the luminance of the light from each OL layer 14 improves.

The pitch of the microlenses 17 in these microlens arrays is preferably within a range of for example 1 to 100 µm. With such a configuration, each pixel 3 can be associated with a microlens array (MLA) composed of more than one microlens 17, and thus the height of the microlens 17 can be kept low. Further, as the gap between the OL layer 14 and the microlens array can be filled in the EL panel 1, a high contrast picture can be achieved with no crosstalk between pixels 3 that could be caused when the light emitted from each pixel 3 is mixed and then condensed by the microlens 17.

Characteristic in the present embodiment is, that the microlenses 17 are provided between the anode 15 and the substrate 11. Furthermore characteristic in the present embodiment is, that as mentioned above, the microlenses 17 have on the side of the anode 15 a convexly curved surface form. With such a configuration, it becomes less likely for the light generated in the OL layer 14 to exceed the critical angle at which the light will be reflected without crossing (passing through) the microlens 17 in the case of crossing the convex surface of the microlens 17 on the side of the anode 15 as compared to the case of crossing the convex surface of the microlens 17 on the side of the substrate 11. Therefore, forming the convex surface of the microlens 17 on the side of the anode 15 will lead to an increased output efficiency of light generated by the OL layer 14 and the EL panel 1 with reduced electrical power consumption can be composed.

The EL panel 1 being of the above configuration, an explanation follows of an example of the behavior of the EL panel 1.

In this EL panel 1, each EL element is driven by the active matrix drive. As mentioned before, the cathodes 13 and the anodes 15 compose a matrix structure, and by applying a voltage between a particular cathode 13 and a particular anode 15 the pixel 3 at the intersection between them is selected, i.e., the transistor 12 corresponding to this pixel is controlled, and due to the operation of that transistor 12, a current will flow in the OL layer 14 that is provided between the cathode 13 and the anode 15, thus inducing the OL layer 14 to emit light.

The light generated by the OL layer 14 crosses the anode 15 that is transparent and the resin 5 that has a low refractive index, and enters the microlens 17. As the microlens 17 has a higher refractive index than the resin 5, the light generated by the OL layer 14 is refracted, crosses the substrate 11 and is emitted to the outside part of the EL panel 1. At this instant, as the microlens 17 has a convex surface on the side of the anode 15, the light from the OL layer 14 can cross the substrate 11 efficiently without being affected by the critical angle at the boundary between the microlens 17 and the substrate 11.

Therefore, compared to the prior art, either can the efficiency of the light output and the luminance of the light from the OL layer 14 be increased with the EL panel 1 (with the same power consumption), or the power consumption can be decreased (with the same luminance).

FIGs. 2 to 7 are sectional views illustrating individual steps of one embodiment of the manufacturing method of the EL panel 1 shown in FIG. 1.

### Forming the switching element etc.

First, as shown in FIG. 2a, a transparent substrate 11 of a non-alkali glass material for example is prepared. On this substrate 11, wirings 7 constituting the circuit, transistors 12 being for example polycrystalline silicon thin film transistors, condensers and the like are formed.

### Forming the microlens

As shown in FIG. 2b, on the substrate 11 on which the transistors 12 and other elements have been formed, a film is formed of a resin (photosensitive high refractive index resin 17a) as a base material for forming the microlenses 17. As this resin 17a, for example MFR-344H made by JRS with a refractive index (nD) of 1.62 is used. Further, as a method of forming the film of the resin 17a, for example spin coating is used. The film of resin 17a is formed by spin coating with a film thickness of 3.0 µm for example. Lens patterns smaller than a pixel 3 are formed of about 33 µm square by applying photolithography technology against the resin 17a formed in such a way.

The substrate 11 onto which lens patterns as shown in FIG. 2b have been formed is then processed by reflow treatment by putting it into a clean oven at 180 °C for 30 minutes for example, and a lens form as shown in FIG. 3a is formed corresponding to the form of the microlenses 17 that refracts the light from the OL layer 14.

### Resin accumulating and hardening

Next, an acrylic resin with a refractive index of about 1.38 is applied by spin coating or the like onto the surface of the substrate 11 on which, among others, the microlenses 17 are formed, and by putting it into a clean oven with an atmosphere of about 180 °C for about 30 minutes the surface of this acrylic resin is caused to reflow, and planarization is carried out resulting in the layer of resin 5 shown in FIG. 3b. The planarized resin 5 is composed so as to cover the microlenses 17 and the other elements formed on the substrate 11.

### Forming the first electrodes

On the surface of the resin 5, a resist (not shown) is coated, and by dry etching using oxygen for example, the opening parts 15a are formed at desired positions as shown in FIG. 4a.

On part of the surface of the resin 5 and in these opening parts 15a, a film of about 100 nm including for example mainly indium tin oxide (ITO) is formed by sputtering as shown in FIG. 4b, and, patterning of the film to obtain the anodes 15 of the pixels 3 is carried out by a photolithographic technology.

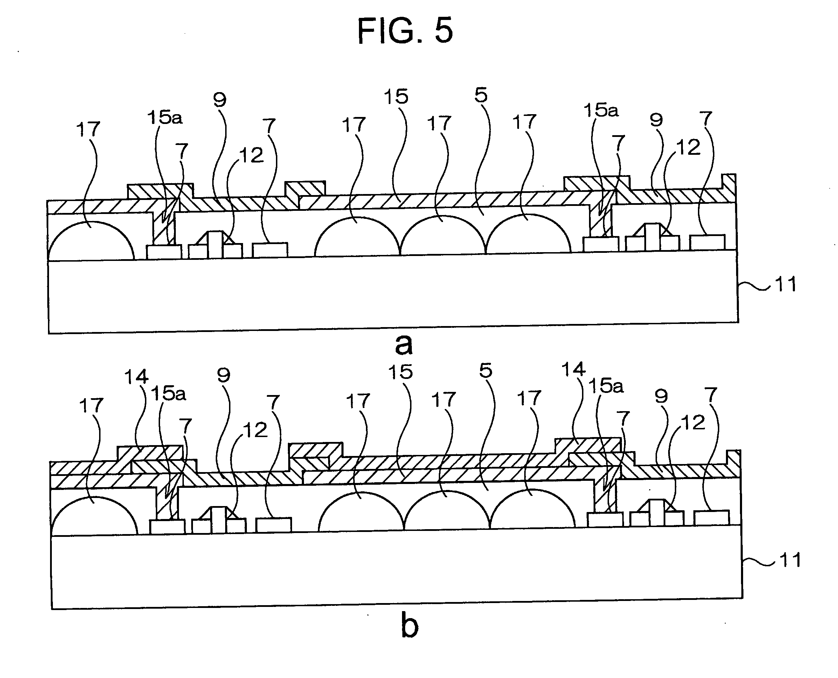

Furthermore, by forming a film of silicon oxide or the like between adjacent anodes 15, as shown in FIG. 5a, the insulating layers 9 are formed. By forming the insulating layers 9, the division of the pixels 3 becomes definite.

### Forming the luminescent layers

Next, as shown in FIG. 5b, an OL layer 14 is formed on each anode 15 by evaporation for example.

### Forming the second electrodes

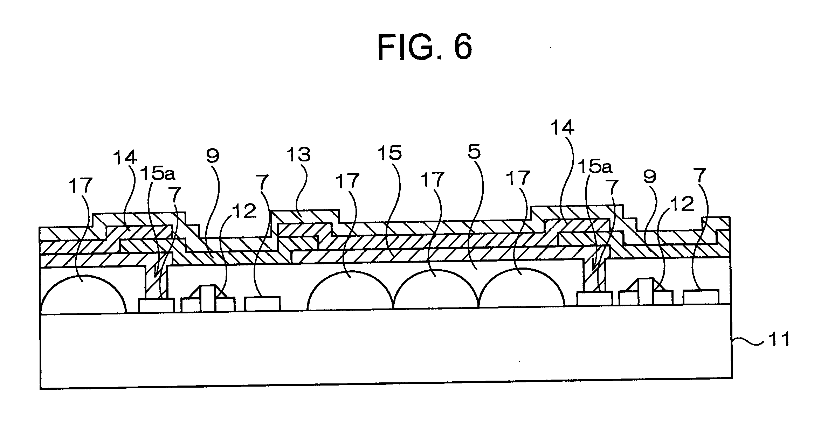

Next, as shown in FIG. 6, the cathodes 13 are formed on the OL layers 14 and the insulating layers 9. Next, though not shown, defined sealing is carried out, and as shown in FIG. 1, the active matrix driven EL panel 1 having the microlenses 17 is completed.

With the EL panel 1 according to a preferred embodiment of the present invention having microlens arrays formed in this way, compared with organic EL panels without microlens arrays, about twice the luminance can be achieved by applying the same driving voltage, and also the luminance efficiency is about double. Further, with such a manufacturing method of the EL panel 1, the microlenses 17 can be easily formed by performing photolithographic treatment and reflow treatment on the photosensitive high refractive index resin 17a, as shown in FIG. 2b, before forming the OL layers 14.

Therefore, it can be avoided that the OL layers 14 being sensitive to heat are negatively affected when the microlenses 17 are formed. Further, not only can the luminance efficiency be increased for the EL panel 1 having the microlens arrays, but providing microlenses 17 having a convex surface on the side of the anode 15 results in an increase of the margin of the critical angle at which the light from the OL layer 14 is reflected by the microlens 17, and thus, the output efficiency of light can be further improved. Therefore, at a luminance that is the same as that of conventional organic EL panels, with a lower power consumption than conventionally, the luminous lifetime can be lengthened. Consequently, an advantage such as the above-mentioned one can be also obtained for a display device equipped with the EL panel 1.

Further, in the above embodiment, as shown in FIG. 3a, when forming the resin 5 on the substrate 11 on which the microlenses 17 and the other elements have been formed, planarization is carried out by causing reflow at a given temperature, after applying an acrylic resin by spin coating as a base material for the resin 5. Planarization, though, may also be carried out by a method such as the one described in the following.

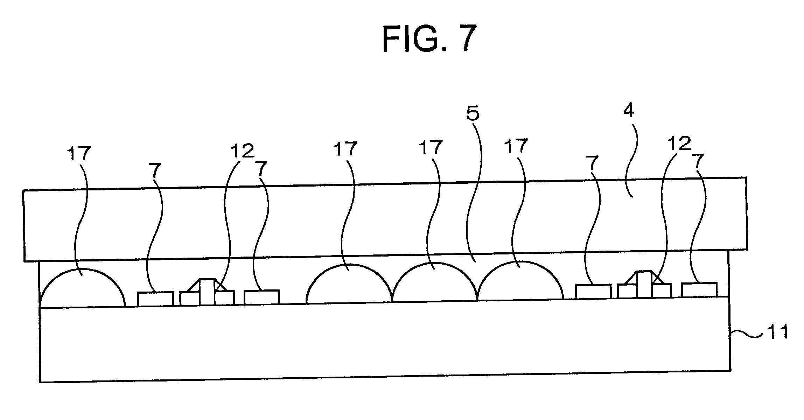

Concretely, as shown in FIG. 7, on the substrate 11 on which the microlenses 17 etc. have been formed, an acrylic resin with a refractive index of 1.38 for example is applied as the resin 5. As such an acrylic resin, World Rock No. 7702 produced by Kyoritsu Chemical can be used for example. The acrylic resin applied onto the substrate 11, as shown in FIG. 7, then undergoes an adhesion and hardening process to hold a quartz substrate (glass substrate) 4 of a thickness of for example 3 mm.

It is preferable to perform a water repellency treatment on the surface of the quartz substrate 4 before it is brought into contact with the resin 5. As a method for performing such a water repellency treatment on the surface of the quartz substrate 4, a silane coupling agent or the like such as HMDS (hexamethyldisilazane) are adequate. Alternatively, plasma deposition by CF gas can be given as an example.

Next, the quartz substrate 4 is taken off, and as shown in FIG. 3b, the surface of the resin 5 undergoes planarization. As the quartz substrate 4 had undergone the water repellency treatment, the adhesion force of the resin 5 being originally adhesive for example, is almost reduced to zero, and the quartz substrate 4 can be removed easily. Taking over the smooth surface form of the quartz substrate 4, the surface of the resin 5 from which the quartz substrate 4 has been removed can be made to be smooth. In the resin 5 that has undergone such smoothing, the opening parts 15a are formed as described before.

The present invention is not limited to the above-described embodiment, and various modifications can be made within the scope of the Claims. For example, in each of the above configurations of the embodiment, part of them can be omitted and arbitrarily combined to differ from the above. Further, in the above embodiment, a silicon oxide film of for example 60 nm may be inserted between the resin 5 and the anodes 15. With such a configuration, the adhesion can be improved between the resin 5 and the anodes 15.

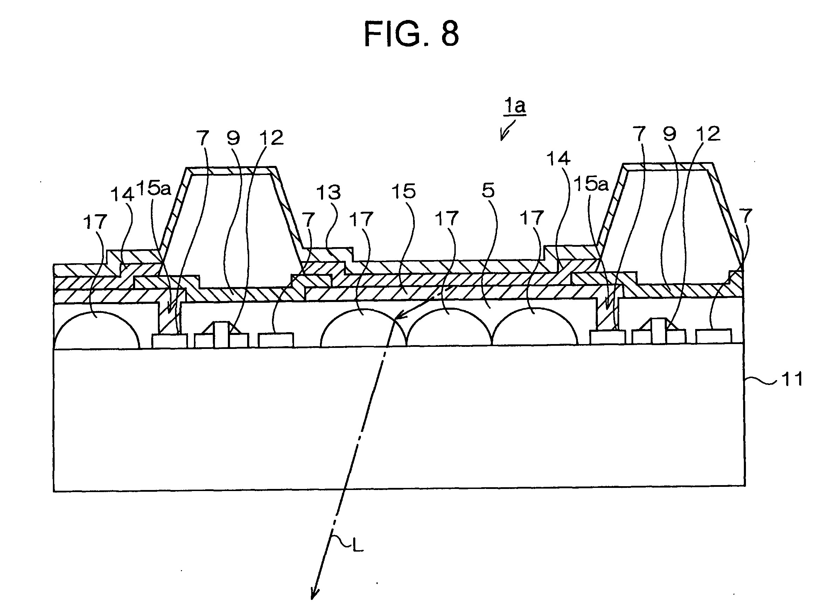

Further, in the above embodiment, the EL panel 1 is explained as using a low-molecular organic luminescent layer for the EL element for example, but, as shown in FIG. 8, a macro-molecule organic layer EL element can also be used to obtain the same effect. For example, when manufacturing a full color panel, the high-molecular organic EL material can be selectively applied as a liquid by using an inkjet process. Therefore, if a wall called bank is formed on the panel between pixels to separate each pixel from the others, so that the liquid does not flow to the other pixels, a panel can be manufactured just as the low-molecular organic EL.

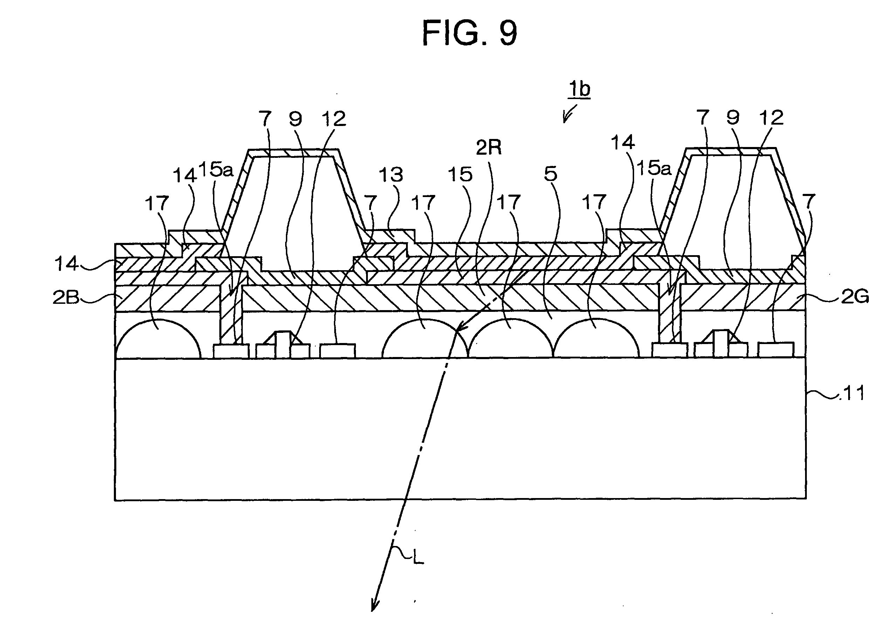

Further, the above embodiment is not limited to a configuration of an EL panel 1a as shown in FIG. 8, but can also be applied to an EL panel 1b with color filter shown in FIG. 9. For manufacturing this EL panel 1 b practically the same processes as the above-mentioned processes can be used, and in addition to the configuration of the EL panel 1a shown in FIG. 8, color filter layers 2B, 2R, 2G are formed by a color filter resist between the resin 5 and the anodes 15. With such a configuration, a full color display device can be achieved that uses an organic EL panel emitting white light.

## Claims

1. A method of manufacturing an organic electroluminescent display panel having surface emitting elements, comprising:
a) forming, on a transparent substrate (11), a plurality of switching elements (12);
b) forming a lens pattern (17a) of microlenses (17) by applying a first transparent resin onto the substrate (11) and subjecting it to a photolithographic treatment, followed by a reflow treatment on the lens pattern (17a) so as to form the microlenses (17);
c) applying a second transparent resin (5) having a lower refractive index than the first transparent resin so as to cover the microlenses (17), and then hardening the second transparent resin (5);
d) forming transparent first electrodes (15) on the second transparent resin (5);
e) forming a respective organic luminescent layer (14) on each first electrode (15); and
f) forming second electrodes (13) on the organic luminescent layers (14), the second electrodes (13) being formed so as to intersect with the first electrodes (15) to define a matrix structure;
wherein each switching element (12) is connected to one of said first and one of said second electrodes (13) so as to be controlled by the respective first electrode (15) second electrode (13) and to control the light-emitting state of the organic luminescent layer (14) provided between that respective first electrode (15) and second electrode (13).

2. The method according to Claim 1, wherein step c) comprises applying the second transparent resin (5) and then hardening it while pressing a flat plate (4) against it.

3. The method according to Claim 1 or 2, wherein step b) comprises applying a film of the second transparent resin (5) onto the substrate (11) by spin coating.

4. The method according to any one of Claims 1 through 3, wherein step b) comprises forming the microlenses (17) so as to have a convexly curved surface on the side facing the first electrode (15).

5. An organic electroluminescent display panel, comprising:
a transparent substrate (11);
switching elements (12) controlled by transparent first electrodes (15) and second electrodes (13) that are arranged to intersect each other so as to define a matrix form;
surface emitting elements each having an organic luminescent layer (14) whose light-emitting state is controlled by a respective switching element (12), the organic luminescent layer (14) being provided between the first electrode (15) and the second electrode (13) controlling the respective switching element (12); and
a microlens (17) provided between the substrate (11) and each first electrode (15) and having a convexly curved surface on the side facing the first electrode (15).

6. The display panel according to Claim 5, wherein the diameter of the microlens (17) is from 1 µm to 50 µm.

7. The display panel according to Claim 5 or 6, wherein a transparent resin (5) is provided between the microlens (17) and the first electrode (15), the refractive index of the microlens (17) being from 1.5 to 1.8, and the refractive index of the transparent resin (5) being from 1.2 to less than 1.5.

8. The display panel according to any one of Claims 5 to 7, wherein for each organic luminescent layer (14) a plurality of corresponding microlenses (17) is provided.
